(19) Europäisches Patentamt / European Patent Office / Office européen des brevets

(11) **EP 2 694 920 B1**

(12) **FASCICULE DE BREVET EUROPEEN**

(45) Date de publication et mention de la délivrance du brevet:
**10.09.2014 Bulletin 2014/37**

(21) Numéro de dépôt: **12717430.8**

(22) Date de dépôt: **02.04.2012**

(51) Int Cl.:
***G01D 3/00*** *(2006.01)*

(86) Numéro de dépôt international:
**PCT/FR2012/050713**

(87) Numéro de publication internationale:
**WO 2012/136923 (11.10.2012 Gazette 2012/41)**

(54) **PROCEDE DE CORRECTION DE LA MESURE D'UNE TENSION AUX BORNES D'UN CAPTEUR**

VERFAHREN ZUM KORRIGIEREN DER MESSUNG DER SPANNUNG AN DEN ANSCHLÜSSEN EINES SENSORS

METHOD OF CORRECTION OF MEASUREMENT OF TENSION AT THE TERMINALS OF A SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.04.2011 FR 1152939**

(43) Date de publication de la demande:
**12.02.2014 Bulletin 2014/07**

(73) Titulaire: **SAGEM Défense Sécurité**
**75015 Paris (FR)**

(72) Inventeurs:
• **LACOMBE, Bertrand**
**F-75015 Paris (FR)**
• **GENESTE, Nicolas**
**F-75015 Paris (FR)**
• **RAES, Marc**
**F-75015 Paris (FR)**

(74) Mandataire: **Cougard, Jean-Marie et al**
**Cabinet Beau de Loménie**
**158, rue de l'Université**
**75340 Paris Cedex 07 (FR)**

(56) Documents cités:
**FR-A1- 2 542 081 FR-A1- 2 805 889**

**Description**

Arrière-plan de l'invention

L'invention se rapporte au domaine général des capteurs, tels que par exemple des capteurs de température, de pression, de déplacements, etc.

Elle concerne plus particulièrement la compensation d'erreurs de mesure liées à l'impédance de sortie d'un capteur.

L'invention a une application privilégiée mais non limitative dans le domaine aéronautique, où de nombreux capteurs sont utilisés (à bord d'un aéronef par exemple).

En pratique, un capteur est généralement connecté à un calculateur numérique qui est chargé de recevoir et de traiter les données de mesure émises depuis le capteur, le capteur et le calculateur numérique faisant ainsi partie d'une chaîne d'acquisition.

Or, il est connu que, lorsqu'un capteur assimilable à un générateur équivalent de tension en série avec impédance de source est connecté à un calculateur numérique présentant une impédance d'entrée finie, une erreur de mesure se produit si le rapport entre l'impédance de sortie du capteur et l'impédance d'entrée du calculateur n'est pas négligeable. Cette erreur indésirable se produit de manière systématique et dépend directement du type de capteur et du calculateur considéré.

En réalité, même lorsque le type de capteur est figé pour une application donnée, des variations importantes de l'impédance série équivalente du capteur apparaissent souvent d'une pièce à l'autre (variations de production). Dans ce cas, on peut habituellement compenser au mieux la moitié de l'erreur due à la variation de l'impédance série équivalente du capteur.

En outre, pour certains types de capteurs (potentiomètres par exemple), une variation d'impédance peut même se produire en fonction du point mesuré de cette impédance série équivalente. Dans ce cas, la variation d'impédance série équivalente résultant du point de mesure crée une erreur variant non linéairement en fonction du point de mesure. Cette erreur non linéaire est théoriquement compensable mais la compensation requise complique fortement l'algorithme de conversion de la mesure en grandeur physique au niveau du calculateur numérique, ce qui conduit le plus souvent à l'utilisation de fonctions d'approximation simplifiant cet algorithme aux dépends de la précision atteinte.

Pour certains capteurs, l'erreur induite par ces différences d'impédance peut être significative, allant jusqu'à atteindre l'erreur totale maximale que l'on tolère pour la chaîne d'acquisition en question (fixée à 1% par exemple). Cette erreur d'impédance viendra ainsi s'ajouter aux autres imprécisions qui affectent généralement une chaîne d'acquisition.

Il existe donc un besoin pour compenser de manière simple, rapide et efficace l'erreur de mesure affectant un capteur relié à un calculateur numérique, et plus particulièrement lorsque ce calculateur possède une impédance série équivalente non négligeable devant l'impédance d'entrée du calculateur (aussi appelé « conditionneur »).

De plus, un même calculateur peut être conçu pour traiter différents types de capteur, chaque capteur ayant une impédance de sortie propre qui n'est pas connue. Il n'est donc pas possible d'appliquer une compensation d'erreur *a priori* puisque l'erreur variera selon le capteur utilisé.

Objet et résumé de l'invention

A cet effet, l'invention concerne un procédé de correction de la mesure d'une tension aux bornes de sortie d'un capteur, le capteur étant assimilable à un ensemble comprenant un générateur et une résistance série, chacune des bornes de sortie étant respectivement reliée à une résistance de tirage, le procédé comprenant :

- lorsque le générateur génère une tension déterminée, une étape préliminaire d'évaluation de la résistance série du capteur, l'étape préliminaire comprenant :

  ■ la mesure d'une première tension aux bornes de sortie lorsqu'une première tension de polarisation est appliquée sur chaque résistance de tirage ;
  ■ la mesure d'une deuxième tension aux bornes de sortie lorsqu'une deuxième tension de polarisation différente de la première tension de polarisation est appliquée sur les résistances de tirage ; et
  ■ l'évaluation de la résistance série à partir des première et deuxième tensions ;

- et une étape de correction, à partir de la résistance série, d'une tension mesurée aux bornes de sortie du capteur afin d'en déduire une tension correspondante générée par le générateur.

L'invention permet avantageusement de compenser l'erreur de mesure affectant un capteur relié à un calculateur numérique, cette erreur étant due à l'impédance de sortie du capteur.

Selon une première alternative, la tension à corriger est la première tension.

Selon une deuxième alternative, la tension à corriger est une tension mesurée ultérieurement auxdites première et deuxième tension.

Dans cette deuxième alternative, la première tension de polarisation peut être appliquée sur chaque résistance de tirage lorsque la tension à corriger est mesurée.

Dans un mode de réalisation particulier, l'étape de correction comprend :

- la détermination d'une valeur de compensation fonction de la résistance série et de la tension à corriger ; et
- l'application de la valeur de compensation à la tension à corriger.

D'autre part, ladite évaluation peut être réalisée à partir de la différence entre les première et deuxième tensions.

Selon un mode de réalisation particulier, la tension de polarisation prédéterminée est telle que la deuxième tension est comprise dans la plage d'acquisition du capteur en fonctionnement normal.

Dans ce dernier mode de réalisation, la valeur absolue de la différence entre la première tension de polarisation et la deuxième tension de polarisation peut être sensiblement égale à la tension maximale que peut générer le capteur en fonctionnement normal.

L'invention concerne en outre un équipement de mesure comprenant des résistances de tirage, l'équipement étant apte à mesurer une tension générée à des bornes de sortie d'un capteur lorsque les bornes de sortie sont reliées aux résistances de tirage, le capteur étant assimilable à un ensemble comprenant un générateur et une résistance série, l'équipement comprenant :

- des moyens pour appliquer successivement une première tension de polarisation et une deuxième tension de polarisation sur chacune des résistances de tirage, la deuxième tension de polarisation étant différente de la première tension de polarisation ;
- des moyens pour mesurer, lorsque le générateur génère une tension déterminée et que la première tension de polarisation est appliquée sur les résistances de tirage, une première tension aux bornes de sortie ;
- des moyens pour mesurer, lorsque le générateur génère la tension déterminée et que la deuxième tension de polarisation est appliquée sur les résistances de tirage, une deuxième tension aux bornes de sortie ;

- des moyens d'évaluation de la résistance série à partir des première et deuxième tensions ; et
- des moyens de correction, à partir de la résistance série, d'une tension mesurée aux bornes de sortie du capteur afin d'en déduire une tension correspondante générée par le générateur.

Par ailleurs, la première tension de polarisation peut être une tension nominale pour alimenter les résistances de tirage en fonctionnement normal.

Selon une première alternative, la tension à corriger est la première tension.

Selon une deuxième alternative, la tension à corriger est une tension mesurée ultérieurement auxdites première et deuxième tension.

Dans un mode de réalisation particulier, les moyens de correction sont configurés pour déterminer une valeur de compensation fonction de la résistance série et de la tension à corriger, et pour appliquer la valeur de compensation à la tension à corriger.

Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :

- la figure 1 représente, dans son environnement, un exemple de chaîne d'acquisition en mode différentiel ;
- la figure 2 représente les principales étapes d'un procédé de correction conformément à l'invention ;
- La figure 3 représente, dans son environnement, un exemple de chaîne d'acquisition en mode commun.

Description détaillée d'un mode de réalisation

Comme indiqué précédemment, l'invention se rapporte au domaine général des capteurs et concerne plus particulièrement la compensation d'erreurs de mesure liées à l'impédance de sortie d'un capteur.

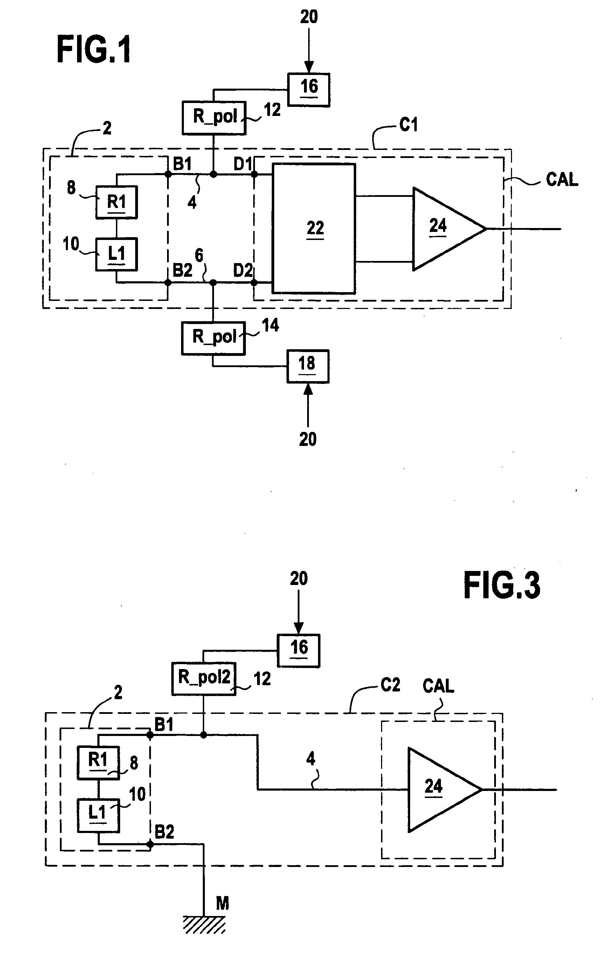

Un premier mode de réalisation de l'invention est à présent décrit en référence à la figure 1. Dans ce mode particulier, l'invention permet la compensation numérique de l'erreur causée par l'impédance série d'un capteur résistif.

Plus particulièrement, la figure 1 représente, dans son environnement, un exemple de chaîne d'acquisition C1 dans laquelle on cherche à corriger l'erreur de mesure induite par les impédances d'un capteur et d'un calculateur numérique.

Plus précisément, cette chaîne d'acquisition C1 comprend un capteur 2, un calculateur numérique CAL, et deux lignes conductrices 4 et 6 reliant respectivement les deux bornes B1 et B2 du capteur 2 aux deux bornes D1 et D2 du calculateur numérique CAL.

Le capteur 2 est assimilable à un générateur équivalent de tension 10 disposé en série d'une résistance 8 dont la valeur est notée Rcapt.

La valeur Rcapt dépend du capteur considéré et est fournie par le fabricant. En variante, elle peut être mesurée au cours d'une étape préliminaire.

En pratique, lorsque le capteur 2 est en cours de fonctionnement, le générateur équivalent de tension 10 génère une tension équivalente Vcapt représentative d'une grandeur physique (température, pression...). Cette tension équivalente Vcapt est cependant affectée par la résistance série Rcapt du capteur 10 de sorte que la tension de sortie Vmes que l'on mesure aux bornes de sortie B1 et B2 est différente de la tension équivalente Vcapt générée effectivement par le générateur 10. Autrement dit, la tension de sortie Vmes aux bornes de sortie B1 et B2 comprend une erreur résultant de la résistance de sortie du capteur 2. C'est pourquoi, il est nécessaire de corriger la tension de sortie de sortie Vmes mesurée aux bornes B1 et B2 du capteur 2 afin de déterminer la tension équivalente correspondante Vcapt qui est en réalité générée par le générateur 10.

Dans l'exemple considéré ici, le capteur 2 est un capteur de type résistif (de pression par exemple). Il s'agit par exemple d'un pont de jauges. L'exemple présenté ici est bien entendu dépourvu de tout caractère limitatif. On notera en particulier que le capteur 2 peut également être un capteur inductif et/ou capacitif, permettant de détecter d'autres variables, telles que la température, la pression, la vitesse, etc. L'impédance série du capteur 2 pourrait ainsi comprendre un élément inductif non représenté sur la figure.

Le mode de réalisation envisagé ici s'effectue en mode différentiel. Toutefois, l'invention peut également s'appliquer en mode commun, comme décrit ultérieurement en référence à la **figure 3.**

D'autre part, en plus d'être connectée à la borne D1 (respectivement D2) du calculateur numérique CAL, la borne B1 (respectivement B2) du capteur 2 est reliée à une résistance dite de tirage 12 (respectivement 14), connue de l'homme du métier. La résistance de tirage 12 correspond à un niveau de potentiel haut (en anglais « pull-up resistor »), tandis que la résistance de tirage 14 correspond à un niveau de potentiel bas (en anglais « pull-down resistor »). La valeur des résistances de tirage 12 et 14 est respectivement notée Rpol1 et Rpol2.

Dans l'exemple envisagé, les résistances de tirage 12 et 14 sont connectées respectivement aux convertisseurs numérique-analogique 16 et 18, ces derniers étant aptes à appliquer des tensions de polarisation respectives. Ces convertisseurs numérique-analogique peuvent être eux-mêmes commandés par différents composants. Dans cet exemple, les convertisseurs numérique-analogique 16 et 18 sont commandés notamment par un coeur numérique 20 d'un système électronique.

Par ailleurs, le calculateur numérique CAL considéré ici comprend en outre un filtre mode commun/mode différentiel 22, suivi d'un amplificateur 24, permettant d'améliorer le rapport signal-à-bruit du signal de mesure délivré par le capteur 2. Les éléments constituant un calculateur numérique ainsi que leurs principes de fonctionnement sont connus de l'homme du métier et ne seront pas détaillés davantage ici.

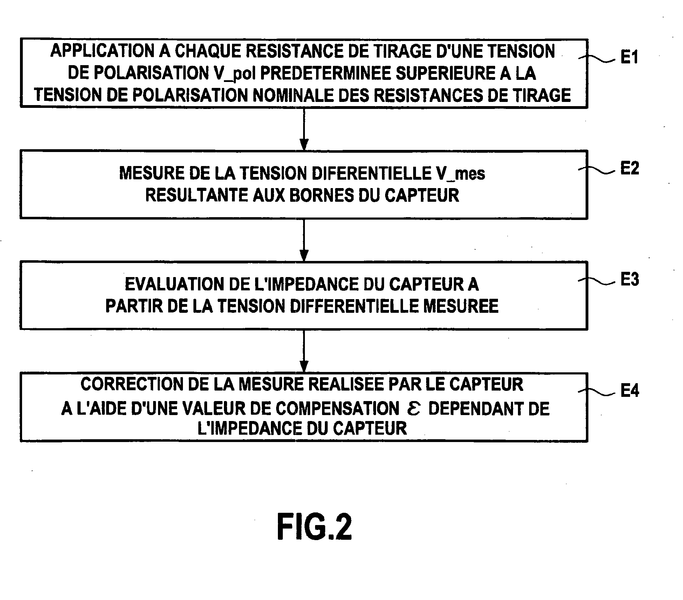

Les principales étapes (E1 et E2) du procédé de correction de l'invention appliqué à la chaîne d'acquisition C1 de la figure 1 sont à présent décrites en référence à la **figure 2.**

Dans ce mode de réalisation, le procédé de correction est réalisé afin de corriger une tension de sortie mesurée aux bornes de sorties B1 et B2 du capteur 2.

Pour ce faire, on réalise tout d'abord une étape préliminaire E1 d'évaluation de l'impédance série Rcapt du capteur de mesure 2 (étape E1). Lors de cette étape, le générateur 10 génère une tension déterminée notée Vcapt. L'étape E1 comprend la réalisation des sous-étapes E11, E12 et E13.

Plus précisément, on réalise lors de l'étape E1 la mesure d'une première tension de sortie Vmes1 générée par le capteur 2 aux bornes de sortie B1 et B2 (sous-étape E11). Cette première tension Vmes1 est mesurée par le calculateur 22 lorsqu'une première tension de polarisation Vpol_1 est appliquée sur les résistances de tirage 12 et 14. Cette tension Vpol_1 est une tension différentielle appliquée par les convertisseurs numérique-analogique 16 et 18.

Dans le mode de réalisation décrit ici, la première tension de polarisation Vpol_1 est la tension de polarisation nominale des résistances de tirage 12 et 14. On comprendra cependant que la tension de polarisation Vpol_1 peut être différente de la tension de polarisation nominale.

On entend dans ce document par « tension de polarisation nominale » la tension de polarisation usuellement appliquée aux bornes des résistances de tirage 12 et 14 pour garantir un fonctionnement normal du capteur 2. Cette tension dépend bien entendu des caractéristiques du capteur 2 et sa détermination s'inscrit dans les compétences ordinaires de l'homme du métier.

On réalise ensuite la mesure d'une deuxième tension de sortie Vmes2 générée par le capteur 2 aux bornes B1 et B2 (sous-étape E12). Cette deuxième tension Vmes2 est mesurée par le calculateur 22 lorsqu'une deuxième tension de polarisation Vpol_2 différente de la première tension de polarisation Vpol_1 est appliquée sur les résistances de tirage 12 et 14. Cette tension Vpol_2 est également une tension différentielle appliquée sur les résistances de tirage par les convertisseurs numérique-analogique 16 et 18.

On comprendra que, suivant le type de capteur utilisé ou le schéma du conditionneur, l'homme de l'art pourra décider d'injecter une tension de polarisation différentielle positive ou négative sur les résistances de tirage.

Comme indiqué ci-avant, il est nécessaire que la tension de polarisation Vpol_2 soit différente de la tension de polarisation nominale Vpol_1 pour pouvoir évaluer la résistance série Rcapt.

En pratique, la tension de polarisation Vpol_2 est généralement choisie de manière à ce que la deuxième tension Vmes2 soit comprise dans la plage d'acquisition normale du capteur 2, c'est-à-dire, dans la plage de tension de sortie du capteur 2 en fonctionnement normal.

Sous réserve de la contrainte ci-dessus, la Déposante a constaté que plus l'écart (en valeur absolue) entre Vpol_1 et Vpol_2 est important, plus la détermination de la résistance série du capteur est précise. En effet, en fonctionnement normal du capteur 2, la tension de polarisation Vpol_1 est suffisamment faible pour ne pas perturber la mesure de la tension de sortie du capteur 2. Toutefois, pour évaluer précisément l'impédance série Rcapt du capteur 2, la tension de polarisation Vpol_2 est choisie suffisamment forte, ou suffisamment différente de la tension de polarisation nominale Vpol_1, afin de modifier la tension de sortie de manière significative par rapport au fonctionnement normal. De cette manière, il est possible d'évaluer l'impédance du capteur 2 avec une grande précision.

Typiquement, Vpol_2 est choisie de telle manière que la valeur absolue de la différence entre la tension de polarisation nominale Vpol_1 et la tension de polarisation prédéterminée Vpol_2 soit sensiblement égale à la tension maximale Vmax que l'on peut obtenir aux bornes de sortie B1 et B2 en fonctionnement normal du capteur 2. On a ainsi :

$$|Vpol\_1 - Vpol\_2| = Vmax \pm 10\%$$

Dans un mode de réalisation particulier, on a :

$$|Vpol\_1 - Vpol\_2| = Vmax \pm 5\%$$

De cette manière, il est possible de minimiser la différence ∆Vmes entre les tensions Vmes1 et Vmes2 mesurées respectivement lors des sous-étapes E11 et E12 aux bornes de sorties B1 et B2 du capteur 2. Une différence ∆Vmes faible est avantageuse en ce qu'elle permet de réaliser des mesures de tension aux bornes B1 et B2 du capteur sans changer le gain de la chaîne d'acquisition C1. Si les tensions Vmes1 et Vmes2 sont proches l'une de l'autre, l'erreur due à la chaîne de conditionnement (gain et décalage de la chaîne) est fortement minimisée lors l'étape E1.

Dans un mode de réalisation particulier, la tension de polarisation Vpol_2 est fixée de manière à être supérieure ou égale en valeur absolue à la tension de polarisation nominale Vpol_1.

Une fois les sous-étapes E11 et E12 effectuées, on évalue la résistance série Rcapt du capteur 2 en fonction des tensions Vmes1 et Vmes2 obtenues lors des sous-étapes E11 et E22, respectivement.

Dans le cas présent, les tensions Vmes1 et Vmes2 peuvent être définies selon les égalités (1) et (2) suivantes :

Egalité (1) :

$$Vmes1 = Vcapt \cdot \frac{R_{pol1} + R_{pol2}}{R_{capt} + R_{pol1} + R_{pol2}} + Vpol\_1 \cdot \frac{R_{capt}}{R_{capt} + R_{pol1} + R_{pol2}}$$

Egalité (2) :

$$Vmes2 = Vcapt \cdot \frac{R_{pol1} + R_{pol2}}{R_{capt} + R_{pol1} + R_{pol2}} + Vpol\_2 \cdot \frac{R_{capt}}{R_{capt} + R_{pol1} + R_{pol2}}$$

Il est ainsi possible, à partir des égalités (1) et (2), d'obtenir l'égalité suivante :

$$\frac{R_{capt}}{R_{capt} + R_{pol1} + R_{pol2}}(Vpol\_2 - Vpol\_1) = Vmes2 - Vmes1$$

, ce qui revient à exprimer la résistance série Rcapt selon l'égalité (3) suivante :

$$R_{capt} = \frac{R_{pol1} + R_{pol2}}{\left(\dfrac{Vpol\_2 - Vpol\_1}{Vmes2 - Vmes1}\right) - 1}$$

L'égalité (3) permet d'obtenir une valeur exacte de la résistance série Rcapt.

La Déposante a en outre déterminé une façon alternative d'évaluer la résistance série Rcapt à partir de Vmes1 et Vmes2. L'égalité (4) ci-dessous permet d'obtenir une valeur approchée de Rcapt lorsque cette dernière est faible devant les résistances de polarisation Rpol1 et Rpol2 :

$$\left[\frac{R_{capt}}{R_{pol1} + R_{pol2}} \cdot \left[1 - o\left[\left(\frac{R_{capt}}{R_{pol1} + R_{pol2}}\right)^2\right]\right] \cdot \left(\Delta V_{pol\_2} - \Delta V_{pol\_1}\right)\right] \approx \left(V_{mes2} - V_{mes1}\right)$$

On obtient ainsi l'égalité **(4)** suivante :

$$R_{capt} \approx \left(R_{pol1} + R_{pol2}\right) \cdot \frac{(Vmes2 - Vmes1)}{(Vpol2 - Vpol1)}$$

Dans l'approximation selon l'égalité (4), les termes du second ordre sont supprimés. Cette méthode de calcul alternative est certes moins précise que l'égalité (3) mais plus simple à mettre en oeuvre pour un calculateur de régulation tel que le calculateur 22.

Dans le cas présent, on suppose, par exemple, que :

- Rpol1 = Rpol2 = 1MΩ
- Vpol_1 = -200mV
- Vpol_2 = +200mV.

On suppose en outre que les mesures de tension lors des sous-étapes E11 et E12 ont abouti respectivement à :

- Vmes1 = 99.7 mV
- Vmes2 = 100.1 mV

On obtient ainsi :

- Rcapt = 2 kΩ à partir de l'égalité (3), et
- Rcapt = 1.998 kΩ à partir de l'égalité (4)

L'égalité (3) permet ainsi de déterminer la valeur exacte de Rcapt tandis que l'égalité (4) conduit à Rcapt à une approximation près. A ce titre, il est possible de déterminer l'erreur d'évaluation (notée ε) introduite dans l'égalité (4) :

$$\varepsilon = 1 - \frac{R_{capt\_appr}}{R_{capt}}$$

où Rcapt_appr est la valeur de la résistance série 8 obtenue à l'aide de l'égalité (4). Dans l'exemple décrit ici, $\varepsilon = 0.1\%$.

De plus, dans cet exemple, on suppose que la tension Vcapt qui est en réalité générée par le générateur 10 lors des mesures des sous-étapes E11 et E12 est telle que : Vcapt = 100 mV. La tension Vmes1 mesurée en E11 présente donc une erreur δV1 telle que :

$$\delta V1 = Vmes1 - Vcapt = -299.7\ \mu V$$

On notera par ailleurs que, dans le cas présent, la différence ΔVmes des tensions mesurées lors des sous-étapes E11 et E12 aux bornes B1 et B2 du capteur 2 est telle que :

$$\Delta Vmes = Vmes2 - Vmes1 = 399.6\mu V$$

Comme indiqué ci-avant, cette différence est suffisamment faible pour s'affranchir de l'influence des variations de gain de la chaîne d'acquisition lors des mesures des sous-étapes E11 et E12.

Une fois l'étape préliminaire d'évaluation E1 effectuée, on réalise une étape de correction E2 d'une tension de sortie mesurée aux bornes de sortie B1 et B2 du capteur 2. Cette étape de correction permet de déduire, à partir de la résistance série Rcapt obtenue à l'étape E1, la tension Vcapt correspondante effectivement générée par le générateur 10 du capteur 2. Deux alternatives sont envisageables dans le cadre de l'invention.

Selon une première alternative, l'étape de correction E2 permet de corriger la tension Vmes1 (obtenue à la sous-étape E11) en fonction de la valeur Rcapt précédemment déterminée. Pour ce faire, on détermine, à partir de Rcapt et de Vmes1, la tension Vcapt1 générée par le générateur 10 lors de la mesure E11.

La tension Vcapt1 peut être déterminée précisément en insérant, dans l'égalité (1), la valeur de Rcapt obtenue à l'étape E1 à l'aide de l'égalité (3) ou (4).

Alternativement, il est possible de calculer Vcapt1 à partir de l'égalité approchée (5) suivante :

$$Vmes1 \approx Vcapt1 \cdot \left[1 - \frac{R_{capt\_appr}}{R_{pol1} + R_{pol2}}\right] + Vpol\_1 \cdot \frac{R_{capt\_appr}}{R_{pol1} + R_{pol2}}$$

On détermine (E2) ensuite, à partir de la valeur Vcapt1 ainsi obtenue, la valeur de compensation Vcomp1 à ajouter à la tension Vmes1 pour obtenir la tension correspondante Vcapt1. Autrement dit, Vcomp1 s'obtient à partir de l'égalité **(6)** suivante :

$$Vcomp1 = Vcapt1 - Vmes1$$

En combinant par exemple les égalités (5) et (6), on définit Vcomp1 selon l'égalité (7) suivante :

$$Vcomp1 = (Vmes1 - Vpol\_1) \cdot \frac{R_{capt\_appr}}{R_{pol1} + R_{pol2}}$$

Dans l'exemple décrit ici, on obtient à partir de l'égalité (7) le résultat suivante : Vcomp1 = 299.401 μV. On peut constater que cette valeur de compensation Vcomp1 est très proche (en valeur absolue) de l'erreur δV1 déterminée

ci-avant ($\delta V1$ = -299.7 $\mu$V).

Selon une deuxième alternative, l'étape de correction E2 permet de corriger une tension autre que la tension Vmes1 (ou Vmes2), à savoir, une tension Vmes3 mesurée ultérieurement aux bornes de sortie B1 et B2 du capteur 2.

Pour ce faire, l'étape E2 comprend la mesure de la tension Vmes3 aux bornes de sortie du capteur 2. Dans cet exemple, la tension de polarisation Vpol_3 appliquée sur les résistances de tirage 12 et 14 lors de la mesure de Vmes3 est la tension nominale des résistances de tirage. On peut cependant envisager qu'il en soit autrement.

On utilise ensuite l'égalité (7) pour déterminer, à partir de Vmes3 et de la résistance série Rcapt obtenue à l'étape E1, la tension de compensation Vcomp3 telle que :

$$Vcomp3 = Vcapt3 - Vmes3$$

où Vcapt3 est la tension correspondante générée par le générateur 10 lors de la mesure de Vmes3. On obtient ainsi :

$$Vcomp3 = (Vmes3 - Vpol\_1) \cdot \frac{R_{capt\_appr}}{R_{pol1} + R_{pol2}}$$

On peut alors, à partir de Vcomp3, corriger la tension Vmes3 afin d'en déduire la tension Vcpat3 correspondante générée par le générateur 10 du capteur 2.

Selon cette deuxième alternative, il n'est donc pas nécessaire de déterminer la valeur de la tension équivalente Vcapt1 fournie par le générateur 10 à la sous-étape E11. La mesure de la tension Vmes1 (et de Vmes2) sert uniquement à déterminer la résistance série Rcapt du capteur 2. Il est ensuite possible, à partir de cette valeur Rcapt, de corriger une quelconque tension mesurée aux bornes de sortie B1 et B2 du capteur. Cette tension quelconque peut avoir été mesurée avant ou après l'étape préliminaire E1 d'évaluation de l'impédance série Rcapt.

L'invention permet également de corriger, à partir de la valeur Rcapt, une pluralité de tensions mesurées successivement aux bornes de sortie B1 et B2 du capteur 2.

On notera par ailleurs que le procédé selon l'invention est applicable aussi bien sur des capteurs destinés à recevoir des tensions de polarisation continues (capteur de type continu) que sur des capteurs destinés à recevoir des tensions de polarisation alternatives (capteur de type alternatif).

Si le capteur 2 est de type continu, la tension de polarisation appliquée V_pol est également continue. Si en revanche le capteur 2 est de type alternatif, on applique sur les résistances de tirage 12 et 14 une tension de polarisation V_pol alternative, par exemple, à la fréquence utile $f_0$ du capteur 2 considéré. On déduira ainsi l'impédance du capteur 2 à sa fréquence utile $f_0$.

On entend ici par fréquence utile $f_0$ du capteur la fréquence usuelle de fonctionnement du capteur, qui est prédéfinie et indiquée par le constructeur du capteur. A noter également que certains types de capteurs inductifs, tels que les roues phoniques par exemple, sont caractérisés par une gamme de fréquence utile. Dans ce cas, la fréquence de variation de la polarisation est de préférence choisie de façon à atteindre un maximum de sensibilité pour l'ensemble capteur, câble et conditionneur (ou calculateur).

L'invention porte également sur un équipement de mesure apte à mettre en oeuvre le procédé de correction de l'invention. Dans le mode de réalisation de la figure 1, l'équipement de mesure comprend :

- le calculateur 22 qui est apte à mesurer la tension de sortie Vmes présente aux bornes de sorties B1 et B2 du capteur 2,
- les résistances de tirage 12 et 14 qui sont reliées aux bornes de sorties B1 et B2 du capteur 2, et
- les convertisseurs 16 et 18 aptes à appliquer différentes tensions de polarisation sur les résistances de tirage 12 et 14.

D'autre part, la **figure 3** représente un autre mode de réalisation où la chaîne d'acquisition (notée C2) est montée en mode commun.

Dans cet exemple, la chaîne d'acquisition C2 comprend un capteur 2 et un calculateur numérique CAL. En revanche, par rapport à la chaîne d'acquisition C1 de la figure 1, une seule ligne conductrice 4 relie le capteur 2 au calculateur CAL.

Plus spécifiquement, le calculateur numérique CAL comprend un amplificateur 24. La borne B2 du capteur 2 est reliée à la masse M, tandis que l'autre borne B1 est reliée à la résistance de tirage 12 par l'intermédiaire de la ligne conductrice 4. En outre, la résistance de tirage 12 correspond à un niveau de potentiel haut. Cet exemple n'est bien sûr pas limitatif. Le capteur 2 pourrait par exemple être connecté à une seule résistance de tirage, de niveau de potentiel bas cette fois.

Le procédé de correction selon l'invention s'applique à la chaîne d'acquisition C2 de la même manière que pour la chaîne C1, la mesure du capteur 2 étant cette fois fonction de la tension à la borne B1 par rapport à la masse.

**Revendications**

1. Procédé de correction de la mesure d'une tension aux bornes de sortie d'un capteur (2), ledit capteur étant assimilable à un ensemble comprenant un générateur (10) et une résistance série (8), chacune desdites bornes de sortie (B1, B2) étant respectivement reliée à une résistance de tirage (12, 14), ledit procédé comprenant :

   - lorsque le générateur (10) génère une tension déterminée (Vcapt1), une étape (E1) préliminaire d'évaluation de la résistance série (8) du capteur, ladite étape préliminaire comprenant :

      ■ la mesure (E11) d'une première tension auxdites bornes de sortie (B1, B2) lorsqu'une première tension de polarisation (Vpol_1) est appliquée sur chaque résistance de tirages (12, 14),
      ■ la mesure (E12) d'une deuxième tension auxdites bornes de sortie (B1, B2) lorsqu'une deuxième tension de polarisation (Vpol_2) différente de la première tension de polarisation est appliquée sur lesdites résistances de tirage (12, 14), et
      ■ l'évaluation (E13) de ladite résistance série (8) à partir desdites première et deuxième tensions ;

   - et une étape (E2) de correction, à partir de ladite résistance série (8) obtenu à l'étape (E1), d'une tension mesurée aux bornes (B1, B2) de sortie du capteur (2) afin d'en déduire une tension correspondante générée par ledit générateur (10).

2. Procédé de correction selon la revendication 1, dans lequel ladite tension à corriger est la première tension.

3. Procédé de correction selon la revendication 1, dans lequel ladite tension à corriger est une tension mesurée ultérieurement auxdites première et deuxième tensions.

4. Procédé de correction selon la revendication 3, dans lequel ladite première tension de polarisation (Vpol_1) est appliquée sur chaque résistance de tirage (12, 14) lorsque ladite tension à corriger est mesurée.

5. Procédé de correction selon l'une quelconque des revendications 1 à 4, dans lequel ladite étape de correction comprend :

   - la détermination d'une valeur de compensation fonction de la résistance série (8) et de ladite tension à corriger ; et
   - l'application de ladite valeur de compensation à ladite tension à corriger.

6. Procédé de correction selon l'une quelconque des revendications 1 à 5, dans lequel ladite évaluation est réalisée à partir de la différence entre les première et deuxième tensions.

7. Procédé de correction selon l'une quelconque des revendications 1 à 6, dans lequel la tension de polarisation prédéterminée est telle que la deuxième tension est comprise dans la plage d'acquisition du capteur (2) en fonctionnement normal.

8. Procédé de correction selon la revendication 7, dans lequel la valeur absolue de la différence entre la première tension de polarisation (Vpol_1) et la deuxième tension de polarisation (Vpol_2) est sensiblement égale à la tension maximale que peut générer le capteur (2) en fonctionnement normal.

9. Equipement de mesure comprenant des résistances de tirage (12, 14), ledit équipement étant apte à mesurer une tension (Vmes) générée à des bornes de sortie (81, B2) d'un capteur (2) lorsque lesdites bornes de sortie (B1, B2) sont reliées auxdites résistances de tirage (12, 14) ledit capteur (2) étant assimilable à un ensemble comprenant un générateur (10) et une résistance série (8), ledit équipement comprenant :

   - des moyens (16, 18) pour appliquer successivement une première tension de polarisation (Vpol_1) et une deuxième tension de polarisation (Vpol_2) sur chacune desdites résistances de tirage (12, 14), ladite deuxième tension de polarisation étant différente de la première tension de polarisation ;

- des moyens (22) pour mesurer, lorsque le générateur (10) génère une tension déterminée et que la première tension de polarisation (Vpol_1) est appliquée sur lesdites résistances de tirage (12, 14), une première tension auxdites bornes de sortie (B1, B2);
- des moyens (22) pour mesurer, lorsque le générateur génère la tension déterminée et que la deuxième tension de polarisation (Vpol_2) est appliquée sur lesdites résistances de tirage (12, 14), une deuxième tension auxdites bornes de sortie (B1, B2) ;
- des moyens d'évaluation de ladite résistance série (8) à partir desdites première et deuxième tensions ; et
- des moyens de correction, à partir de ladite résistance série (8), d'une tension mesurée aux bornes de sortie du capteur (2) afin d'en déduire une tension correspondante générée par ledit genérateur (10).

10. Equipement de mesure selon la revendication 9 dans lequel ladite première tension de polarisation (Vpol_1) est une tension nominale pour alimenter les résistances de tirage (12, 14) en fonctionnement normal.

11. Equipement de mesure selon la revendication 9 ou 10, dans lequel ladite tension à corriger est la première tension.

12. Equipement de mesure selon la revendication 9 ou 10, dans lequel ladite tension à corriger est une tension mesurée ultérieurement auxdites première et deuxième tension.

13. Equipement de mesure selon l'une quelconque des revendications 9 à 12, dans lequel les moyens de correction sont configurés pour déterminer une valeur de compensation fonction de la résistance série (8) et de ladite tension à corriger, et pour appliquer ladite valeur de compensation à ladite tension à corriger.


**Patentansprüche**

1. Verfahren zur Korrektur der Messung einer Spannung an den Ausgangsklemmen eines Sensors (2), wobei der Sensor einer Einheit gleichzusetzen ist, umfassend einen Generator (10) und einen seriellen Widerstand (8), wobei jede der Ausgangsklemmen (B1, B2) jeweils mit einem Zugwiderstand (12, 14) verbunden ist, wobei das Verfahren umfasst:

- wenn der Generator (10) eine bestimmte Spannung (Vcapt1) erzeugt, einen vorherigen Schritt (E1) der Bewertung des seriellen Widerstandes (8) des Sensors, wobei der vorherige Schritt umfasst:

- das Messen (E11) einer ersten Spannung an den Ausgangsklemmen (B1, B2), wenn eine erste Polarisationsspannung (Vpol_1) an jeden Zugwiderstand (12, 14) angelegt wird,
- das Messen (E12) einer zweiten Spannung an den Ausgangsklemmen (B1, B2), wenn eine zweite Polarisationsspannung (Vpol_2), die sich von der ersten Polarisationsspannung unterscheidet, an den Zugwiderständen (12, 14) angelegt wird, und
- Bewertung (E13) des seriellen Widerstandes (8) auf Basis der ersten und zweiten Spannung,

- und einen Schritt (E2) der Korrektur einer an den Ausgangsklemmen (B1, B2) des Sensors (2) gemessenen Spannung anhand des seriellen Widerstandes (8), der in Schritt (E1) erhalten wurde, um davon eine entsprechende vom Generator (10) erzeugte Spannung abzuleiten.

2. Korrekturverfahren nach Anspruch 1, bei dem die zu korrigierende Spannung die erste Spannung ist.

3. Korrekturverfahren nach Anspruch 1, bei dem die zu korrigierende Spannung eine später als die erste und zweite Spannung gemessene Spannung ist.

4. Korrekturverfahren nach Anspruch 3, bei dem die erste Polarisationsspannung (Vpol_1) an jeden Zugwiderstand (12, 14) angelegt wird, wenn die zu korrigierende Spannung gemessen wird.

5. Korrekturverfahren nach einem der Ansprüche 1 bis 4, bei dem der Korrekturschritt umfasst:

- die Bestimmung eines Kompensationswertes, der von dem seriellen Widerstand (8) und der zu korrigierenden Spannung abhängt, und
- das Anlegen des Kompensationswertes an die zu korrigierende Spannung.

6. Korrekturverfahren nach einem der Ansprüche 1 bis 5, bei dem die Bewertung anhand der Differenz zwischen der ersten und der zweien Spannung erfolgt.

7. Korrekturverfahren nach einem der Ansprüche 1 bis 6, bei dem die vorbestimmte Polarisationsspannung derart ist, dass die zweite Spannung in dem Erfassungsbereich des Sensors (2) bei Normalbetrieb liegt.

8. Korrekturverfahren nach Anspruch 7, bei dem der Absolutwert der Differenz zwischen der ersten Polarisationsspannung (Vpol_1) und der zweiten Polarisationsspannung (Vpol_1) im Wesentlichen gleich der maximalen Spannung ist, die der Sensor (2) bei Normalfunktion erzeugen kann.

9. Messausrüstung, umfassend Zugwiderstände (12, 14), wobei die Ausrüstung geeignet ist, eine Spannung (Vmes) zu messen, die an Ausgangsklemmen (B1, B2) eines Sensors (2) erzeugt wird, wenn die Ausgangsklemmen (B1, B2) mit den Zugwiderständen (12, 14) verbunden sind, wobei der Sensor (2) einer Einheit gleichzusetzen ist, umfassend einen Generator (10) und einen seriellen Widerstand (8), wobei die Ausrüstung umfasst:

- Mittel (16, 18) zum aufeinanderfolgenden Anlegen einer ersten Polarisationsspannung (Vpol_1) und einer zweite Polarisationsspannung (Vpol_2) an jeden der Zugwiderstände (12, 14), wobei die zweite Polarisationsspannung zur ersten Polarisationsspannung unterschiedlich ist,
- Mittel (22) zum Messen einer ersten Spannung an den Ausgangsklemmen (B1, B2), wenn der Generator (10) eine bestimmte Spannung erzeugt, und wenn die erste Polarisationsspannung (Vpol_1) an die Zugwiderstände (12, 14) angelegt wird,
- Mittel (22) zum Messen einer zweiten Spannung an den Ausgangsklemmen (B1, B2), wenn der Generator die bestimmte Spannung erzeugt, und wenn die zweite Polarisationsspannung (Vpol_2) an die Zugwiderstände (12, 14) angelegt wird,
- Mittel zur Bewertung des seriellen Widerstandes (8) auf Basis der ersten und zweiten Spannung, und
- Mittel zur Korrektur einer an den Ausgangsklemmen des Sensors (2) gemessenen Spannung anhand des seriellen Widerstandes (8), um davon eine entsprechende vom Generator (10) erzeugte Spannung abzuleiten.

10. Messausrüstung nach Anspruch 9, bei der die erste Polarisationsspannung (Vpol_1) eine Nominalspannung ist, um die Zugwiderstände (12, 14) bei Normalfunktion zu versorgen.

11. Messausrüstung nach Anspruch 9 oder 10, bei der die zu korrigierende Spannung die erste Spannung ist.

12. Messausrüstung nach Anspruch 9 oder 10, bei der die zu korrigierende Spannung eine später als die erste und zweite Spannung gemessene Spannung ist.

13. Messausrüstung nach einem der Ansprüche 9 bis 12, bei der die Korrekturmittel derart ausgeführt sind, dass sie einen Kompensationswert in Abhängigkeit von dem seriellen Widerstand (8) und der zu korrigierenden Spannung bestimmen und den Kompensationswert an die zu korrigierende Spannung anlegen.

**Claims**

1. A method for correcting the measurement of a voltage across the output terminals of a sensor (2), wherein said sensor can be assimilated to an assembly comprising a generator (10) and a series resistance (8), each of said output terminals (B1, B2) being respectively connected to a pull-up/down resistor (12, 14), said method comprising:

- when the generator (10) generates a determined voltage (Vcapt1), a preliminary step (E1) for evaluating the series resistance (8) of the sensor, said preliminary step comprising:

■ the measurement (E11) of a first voltage across said output terminals (B1, B2) when a first bias voltage (Vpol_1) is applied on each pull-up/down resistor (12, 14);
■ the measurement (E12) of a second voltage across said output terminals (B1, B2) when a second bias voltage (Vpol_2) different from the first bias voltage is applied on said pull-up/down resistors (12, 14) ; and
■ the evaluation (E13) of said series resistance (8) from said first and second voltages; and

- a step (E2) for correcting, from said series resistance (8) obtained at step (E1), a voltage measured across the output terminals (B1, B2) of the sensor (2) in order to infer therefrom a corresponding voltage generated by said generator (10).

2.  The correction method according to claim 1, wherein said voltage to be corrected is the first voltage.

3.  The correction method according to claim 1, wherein said voltage to be corrected is a voltage measured subsequently to said first and second voltages.

4.  The correction method according to claim 3, wherein said first bias voltage (Vpol_1) is applied on each pull-up/down resistor (12, 14) when said voltage to be corrected is measured.

5.  The correction method according to any of claims 1 to 4, wherein said correction step comprises:

    - the determination of a compensation value depending on the series resistance (8) and on said voltage to be corrected; and
    - the application of said compensation value to said voltage to be corrected.

6.  The correction method according to any of claims 1 to 5, wherein said evaluation is made from the difference between the first and second voltages.

7.  The correction method according to any of claims 1 to 6, wherein the predetermined bias voltage is such that the second voltage is comprised within the acquisition range of the sensor (2) during normal operation.

8.  The correction method according to claim 7, wherein the absolute value of the difference between the first bias voltage (Vpol_1) and the second bias voltage (Vpol-2) is substantially equal to the maximum voltage which may be generated by the sensor (2) during normal operation.

9.  Measurement equipment comprising pull-up/down resistors (12, 14), said equipment being capable of measuring a voltage (Vmes) generated across the output terminals (B1, B2) of a sensor (2) when said output terminals (B1, B2) are connected to said pull-up/down resistors (12,14), wherein said sensor (2) can be assimilated to an assembly comprising a generator (10) and a series resistance (8), said equipment comprising:

    - means (16, 18) for successively applying a first bias voltage (Vpol_1) and a second bias voltage (Vpol_2) on each of said pull-up/down resistors (12, 14), said second bias voltage (Vpol_1) being different from the first bias voltage;
    - means (22) for measuring, when the generator (10) generates a determined voltage and the first bias voltage (Vpol_1) is applied onto said pull-up/down resistors (12,14), a first voltage across said output terminals (B1, B2);
    - means (22) for measuring, when the generator generates the determined voltage and the second bias voltage (Vpol_2) is applied on said pull-up/down resistors (12,14), a second voltage across said output terminals (B1, B2);
    - means for evaluating said series resistance (8) from said first and second voltages; and
    - means for correcting, from said series resistance (8), a voltage measured across the output terminals of the sensor (2) in order to infer therefrom a corresponding voltage generated by said generator (10).

10. Measurement equipment according to claim 9, wherein said first bias voltage (Vpol_1) is a rated voltage for powering the pull-up/down resistors (12,14) during normal operation.

11. Measurement equipment according to claim 9 or 10, wherein said voltage to be corrected is the first voltage.

12. Measurement equipment according to claim 9 or 10, wherein said voltage to be corrected is a voltage measured subsequently to said first and second voltages.

13. Measurement equipment according to any of claims 9 to 12, wherein the correction means are configured in order to determine a compensation value depending on the series resistance (8) and on said voltage to be corrected, and for applying said compensation value to said voltage to be corrected.

EP 2 694 920 B1

**FIG.1**

**FIG.3**

13

APPLICATION A CHAQUE RESISTANCE DE TIRAGE D'UNE TENSION DE POLARISATION V_pol PREDETERMINEE SUPERIEURE A LA TENSION DE POLARISATION NOMINALE DES RESISTANCES DE TIRAGE — E1

MESURE DE LA TENSION DIFERENTIELLE V_mes RESULTANTE AUX BORNES DU CAPTEUR — E2

EVALUATION DE L'IMPEDANCE DU CAPTEUR A PARTIR DE LA TENSION DIFFERENTIELLE MESUREE — E3

CORRECTION DE LA MESURE REALISEE PAR LE CAPTEUR A L'AIDE D'UNE VALEUR DE COMPENSATION $\varepsilon$ DEPENDANT DE L'IMPEDANCE DU CAPTEUR — E4

# FIG.2